# FASCICULE DE BREVET EUROPEEN

(11) **EP 3 679 597 B1**
(45) Date de publication et mention de la délivrance du brevet: **01.03.2023**
(21) Numéro de dépôt: 18759990.7
(22) Date de dépôt: 05.09.2018
(51) Int. Cl.: H01J 27/26, F03H 1/00, H01J 37/08

(54) **GÉNÉRATEUR DE FAISCEAU IONIQUE À NANOFILS**
IONENSTRAHLGENERATOR MIT NANODRÄHTEN
ION BEAM GENERATOR WITH NANOWIRES

(30) Priorité: 05.09.2017 FR 1758177
(43) Date de publication de la demande: 15.07.2020
(73) Titulaire: Centre National de la Recherche Scientifique, 75016 Paris (FR)
(72) Inventeur: GIERAK, Jacques, 91220 Le Plessis Pâté (FR); LEBEAU, Noëlle, 92380 Garches (FR)
(74) Mandataire: IPAZ
(86) Numéro de dépôt international: PCT/EP2018/073897
(87) Numéro de publication internationale: WO 2019/048497

(56) Documents cités:
- WO-A1-2011/097180
- WO-A1-2017/021380
- WO-A2-2009/137583
- HILL FRANCES ANN ET AL: "High-Throughput Ionic Liquid Ion Sources Using Arrays of Microfabricated Electrospray Emitters With Integrated Extractor Grid and Carbon Nanotube Flow Control Structures", JOURNAL OF MICROELECTROMECHANICAL SYSTEMS, IEEE SERVICE CENTER, US, vol. 23, no. 5, 1 octobre 2014 (2014-10-01), pages 1237-1248, XP011560293, ISSN: 1057-7157, DOI: 10.1109/JMEMS.2014.2320509 [extrait le 2014-09-29]
- Risaku Toda ET AL: "Manufacturing & Prototyping Fabrication of Gate-Electrode Integrated Carbon-Nanotube Bundle Field Emitters Emission tips and a gate electrode are integrated into a monolithic device", NASA Tech Briefs, 1 avril 2008 (2008-04-01), pages 15-16, XP055487799, Extrait de l'Internet: URL:https://ntrs.nasa.gov/archive/nasa/cas i.ntrs.nasa.gov/20090016139.pdf [extrait le 2018-06-26]
- Harish Manohara ET AL: "Arrays of Bundles of Carbon Nanotubes as Field Emitters", NASA Tech Briefs, 1 février 2007 (2007-02-01), pages 26-27, XP055487812, Extrait de l'Internet: URL:https://ntrs.nasa.gov/archive/nasa/cas i.ntrs.nasa.gov/20090040779.pdf [extrait le 2018-06-26]
- WAN J ET AL: "Carbon nanotubes grown by gas source molecular beam epitaxy", JOURNAL OF CRYSTAL GR, ELSEVIER, AMSTERDAM, NL, vol. 227-228, 1 juillet 2001 (2001-07-01), pages 820-824, XP004250946, ISSN: 0022-0248, DOI: 10.1016/S0022-0248(01)00892-2
- Z LILIENTAL-WEBER ET AL: "VOLUME 79, NUMBER 15 Formation Mechanism of Nanotubes in GaN", PHYSICAL REVIEW LETTERS, vol. 79, no. 15, 13 octobre 1997 (1997-10-13), pages 2835-2838, XP055487839, US ISSN: 0031-9007, DOI: 10.1103/PhysRevLett.79.2835
- WENLIANG WANG ET AL: "A new approach to epitaxially grow high-quality GaN films on Si substrates: the combination of MBE and PLD", SCIENTIFIC REPORTS, vol. 6, no. 1, 22 avril 2016 (2016-04-22), XP055487842, DOI: 10.1038/srep24448

## Description

La présente invention concerne un générateur de faisceau ionique, du type comportant : une électrode d'émission, comprenant une première surface principale ; une électrode d'extraction, comprenant une deuxième surface principale disposée sensiblement en vis-à-vis de la première surface principale, lesdites première et deuxième surfaces principales étant séparées par un espace ; et un générateur électrique apte à appliquer une différence de potentiel entre l'électrode d'émission et l'électrode d'extraction ; l'électrode d'émission comprenant une source d'ions à liquide ionique, ladite électrode d'émission étant ainsi apte à envoyer vers l'électrode d'extraction au moins un faisceau d'ions issus dudit liquide ionique.

Les générateurs de faisceaux ioniques se rapportent à des domaines techniques variés, tels que la gravure à l'échelle nanométrique sur des circuits intégrés, comme décrit dans le document WO2009/027596, ou la fabrication de propulseurs pour satellites de petite taille, comme décrit dans le document WO2016/164004.

Il est connu d'utiliser une source d'ions à liquide ionique pour ces générateurs. Les liquides ioniques sont des sels possédant une température de fusion inférieure à 100°C, voire inférieure à la température ambiante. Ils sont donc à l'état liquide sans nécessiter de chauffage. Par ailleurs, leur très faible pression de vapeur saturante leur permet de rester liquides sous un vide poussé.

Afin d'émettre un faisceau d'ions à partir d'un liquide ionique, il est classique de maintenir une quantité de liquide à la pointe d'une aiguille métallique, puis d'appliquer une tension entre ladite aiguille, ou électrode d'émission, et une autre électrode dite d'extraction. La tension d'extraction génère une émission des ions par un mécanisme d'évaporation de champ. Le champ électrique appliqué au liquide ionique conduit à sa déformation sous forme d'un ménisque conique dénommé cône de Taylor, comme décrit dans le document Proc. R. Soc. Lond. A 280 (1964) 383-397, ou dans le document WO2009/137583.

Les ions sont arrachés à la pointe du cône de Taylor pour former un faisceau en direction de l'électrode d'extraction. Dans le cas d'un propulseur ionique, il est connu d'utiliser un champ d'aiguilles sensiblement identiques, l'électrode d'extraction étant constituée d'une paroi perforée que traversent les différents faisceaux formés à la pointe de chaque aiguille.

Les dispositifs connus présentent plusieurs inconvénients. Les champs d'aiguilles utilisés pour les propulseurs ioniques sont généralement réalisés par gravage d'un bloc de matériau conducteur tel que le graphite, ou approche « top-down ». Un tel procédé rend difficile l'obtention d'aiguilles de forme et de longueur identiques, ce qui affecte l'homogénéité des faisceaux ioniques obtenus.

Par ailleurs, au cours de l'émission se forme une couche de contre-ions qui s'accumulent à la surface des aiguilles en matériau conducteur, comme décrit par exemple dans le document Fedorov et. al., Electrochemistry communications 12 (2010) 296-299. Ce phénomène fait rapidement décroître l'efficacité du générateur. Dans le document WO2016/164004 est décrite la mise en place d'une électrode de polarisation déportée, afin de lutter contre la formation d'une telle couche. Cette solution conduit cependant à des résultats insuffisants.

En outre, les dispositifs connus ne permettent pas de faire circuler efficacement le liquide ionique à la pointe des cônes de Taylor. Il en résulte un appauvrissement du liquide en ions émis et, à l'inverse, une saturation en contre-ions. Le courant ionique obtenu diminue donc rapidement.

Une solution à ce problème est d'inverser la polarité entre les électrodes. Les contre-ions deviennent alors les ions émis. Toutefois, l'inversion fréquente des polarités diminue l'efficacité opérationnelle des générateurs, en raison de temps morts nécessaires à une dépolarisation / repolarisation en inverse.

L'article de Hill et al., "High-Throughput lonic Liquid Ion Sources Using Arrays of Microfabricated Electrospray Emitters With Integrated Extractor Grid and Carbon Nanotube Flow Control Structures", Journal of Microelectromechanical Systems, vol. 23, no. 5, octobre 2014, pages 1237-1248, XP011560293, ISSN: 1057-7157, DOI: 10.1109/JMEMS.2014.2320509 divulgue un générateur de faisceau ionique à partir d'un liquide ionique utilisant un substrat muni de nano-fils.

La présente invention a pour objet de résoudre ces problèmes et de fournir un générateur de faisceau ionique efficace dans la durée et permettant l'émission de courants ioniques d'intensité élevée.

A cet effet, l'invention a pour objet un générateur de faisceau ionique du type précité, dans lequel : l'électrode d'émission comporte un substrat et une pluralité de nanofils s'étendant à partir dudit substrat, sensiblement en direction de l'électrode d'extraction, chacun desdits nanofils ayant une longueur comprise entre 50 nm et 50 µm, préférentiellement comprise entre 100 nm et 1 µm, chacun desdits nanofils ayant un diamètre compris entre 50 nm et 200 nm, une distance minimale entre deux nanofils voisins sur le substrat étant comprise entre 50 nm et 200 nm et préférentiellement égale à environ 150 nm ; la source d'ions à liquide ionique comprend une nappe de liquide ionique formée sur le substrat et immergeant au moins partiellement les nanofils, ladite nappe de liquide ionique formant ainsi au moins partiellement la première surface principale ; et la pluralité de nanofils et le substrat sont électriquement isolants, le générateur électrique étant relié à la nappe de liquide ionique.

Suivant d'autres aspects avantageux de l'invention, le générateur de faisceau ionique comporte l'une ou plusieurs des caractéristiques suivantes, prises isolément ou suivant toutes les combinaisons techniquement possibles :
- les nanofils de l'électrode d'émission sont obtenus par un apport de matière sur le substrat, lesdits nanofils étant préférentiellement réalisés par épitaxie moléculaire ;
- les nanofils sont formés d'un matériau AIN ;
- le substrat de l'électrode d'émission est formé d'un matériau comprenant du silicium ;
- les nanofils s'étendent à partir d'une surface sensiblement plane du substrat ;
- le liquide ionique est un sel d'onium, préférentiellement choisi parmi le tétrafluoroborate de 3-éthyl-1-méthylimidazolium et le bis (trifluorométhyl-sulfonyl)imide de 3-éthyl-1-méthylimidazolium ;
- l'espace séparant les première et deuxième surfaces principales a une longueur comprise entre 100 nm et 50 µm, préférentiellement comprise entre 500 nm et 10 µm ;
- la longueur d'un nanofil est comprise entre 100 nm et 1 µm ; le diamètre d'un nanofil est d'environ 50 nm ; la distance minimale entre deux nanofils voisins sur le substrat est d'environ 150 nm ; et un module de Young des nanofils est supérieur ou égal à 120 GPa et préférentiellement de l'ordre de 150 GPa ;
- l'électrode d'extraction comporte une grille préférentiellement formée de fils tissés ;
- l'électrode d'extraction comporte un feuillet apte à être perforé par un faisceau d'ions issu de l'électrode d'émission ;
- l'électrode d'émission est disposée dans un compartiment fermé de manière étanche par le feuillet.

L'invention se rapporte en outre à un propulseur ionique comprenant un générateur de faisceau ionique tel que décrit ci-dessus.

L'invention se rapporte en outre à un dispositif de nano-fabrication, comprenant un générateur de faisceau ionique tel que décrit ci-dessus.

L'invention sera mieux comprise à la lecture de la description qui va suivre, donnée uniquement à titre d'exemple non limitatif et faite en se référant aux dessins sur lesquels :
- la figure 1 est une représentation schématique en coupe d'un générateur de faisceau ionique selon un premier mode de réalisation de l'invention, avant une première émission de faisceaux ioniques ;
- la figure 2 et la figure 3 sont des vues schématiques de détail du générateur de la figure 1 ;
- la figure 4 est une représentation schématique d'un générateur de faisceau ionique selon un deuxième mode de réalisation de l'invention, au cours d'une émission de faisceaux ioniques ;
- la figure 5 est une représentation schématique d'un générateur de faisceau ionique selon un troisième mode de réalisation de l'invention, au cours d'une émission de faisceaux ioniques ;
- les figures 6 et 7 sont des photographies au microscope électronique représentant des vues de détail du générateur de la figure 1, respectivement avant et après une première émission de faisceaux ioniques ; et
- la figure 8 est un graphique représentant une variation d'un courant ionique émis par le générateur de la figure 1 en fonction de la différence de potentiel appliquée entre les électrodes.

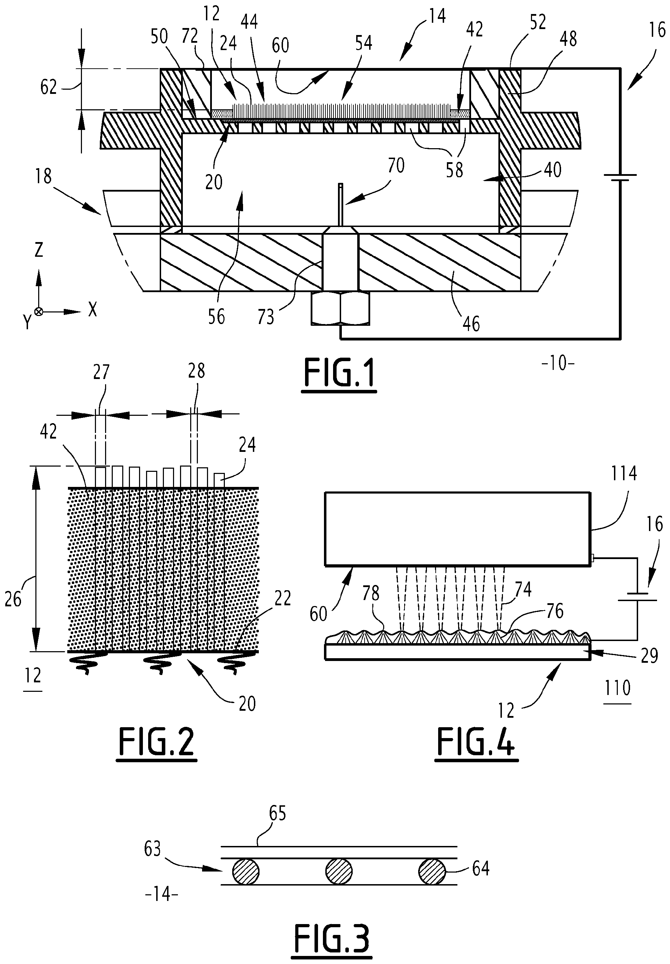

Chacune des figures 1, 4 et 5 représente schématiquement un générateur de faisceau ionique 10, 110, 210, selon respectivement un premier, un deuxième et un troisième modes de réalisation de l'invention. Les figures 2 et 3 montrent des vues de détail du générateur 10 de la figure 1.

A titre indicatif, le générateur 10 de la figure 1 est particulièrement destiné à être intégré dans un propulseur ionique pour l'aérospatiale. Le générateur 110 de la figure 4 est particulièrement destiné à une application en nano-fabrication, par exemple pour des circuits intégrés.

Dans la description qui suit, les éléments communs aux générateurs 10, 110 et 210 seront désignés par les mêmes numéros de référence.

Le générateur de faisceau ionique 10, 110, 210 comprend : une électrode d'émission 12, 212, une électrode d'extraction 14, 114, 214 et un générateur électrique 16. Dans le mode de réalisation de la figure 1, le générateur de faisceau ionique 10 comporte en outre un boîtier 18.

On considère une base orthonormée (X, Y, Z). L'électrode d'émission 12, 212 et l'électrode d'extraction 14, 114, 214 sont disposées sensiblement en vis-à-vis selon la direction Z. Dans la suite de la description, on considère que ladite direction Z représente la verticale et que l'électrode d'émission 12, 212 est située plus bas que l'électrode d'extraction 14, 114, 214.

La figure 2 montre une vue de détail de l'électrode d'émission 12 de la figure 1. L'électrode d'émission 12, 212 comporte un substrat 20. Ledit substrat 20 présente une surface supérieure 22 sensiblement plane, s'étendant notamment selon un plan (X, Y).

Le substrat 20 est formé d'un matériau électriquement isolant, de préférence cristallin. Le matériau du substrat 20 comprend préférentiellement du silicium, rendu isolant par un procédé de nitruration ou d'oxydation de surface.

L'électrode d'émission 12, 212 comporte en outre une pluralité de nanofils 24 s'étendant sensiblement selon Z à partir de ladite surface supérieure 22. Sur la figure 1, les nanofils 24 sont schématisés sous forme agrandie par rapport au boîtier 18.

Les nanofils (*nanowire* en anglais) désignent des nanostructures filiformes dont le diamètre est à l'échelle nanométrique. Dans les modes de réalisation représentés, les nanofils 24 ont une longueur 26 comprise entre 50 nm et 50 µm, préférentiellement comprise entre 100 nm et 1 µm. Par ailleurs, les nanofils 24 ont de préférence un diamètre 27 compris entre 50 nm et 200 nm.

Une distance minimale 28 entre deux nanofils voisins sur le substrat 20 est préférentiellement comprise entre 50 nm et 200 nm et plus préférentiellement égale à environ 100 nm.

De même que le substrat 20, les nanofils 24 sont formés d'un matériau électriquement isolant. Le matériau des nanofils est préférentiellement AIN

De préférence, les nanofils 24 sont obtenus par un apport de matière sur le substrat 20, et non par suppression de matière ou approche « top-down ». L'apport de matière permet en effet d'obtenir une meilleure homogénéité de la taille et de la forme des nanofils.

Selon un exemple ne faisant pas partie de l'invention, les nanofils sont formés par épitaxie moléculaire, à partir de nitrure de gallium (GaN), sur un substrat de silicium cristallin Si<111> préalablement traité en surface. Un tel procédé de formation de nanofils est notamment connu de Largeau et. al., Nanotechnology 19 (2008) 155704. Un exemple de ce procédé sera décrit ci-après.

La surface supérieure 22 du substrat 20, recouverte de nanofils 24, peut présenter une aire variable selon l'utilisation souhaitée du générateur 10, 110, 210. Dans le mode de réalisation de la figure 1, la surface supérieure 22 présente une aire d'environ 1 cm². Le substrat 20 a par exemple la forme d'un carré d'environ 1 cm de côté.

De même, la surface supérieure 22 peut présenter un contour 29 de forme variable, par exemple carrée, rectangle ou arrondie ; dans le cadre d'une application en nano-fabrication, comme pour le générateur 110 de la figure 4, le contour 29 du substrat définit notamment une forme à reproduire par nano-fabrication comme décrit ci-après.

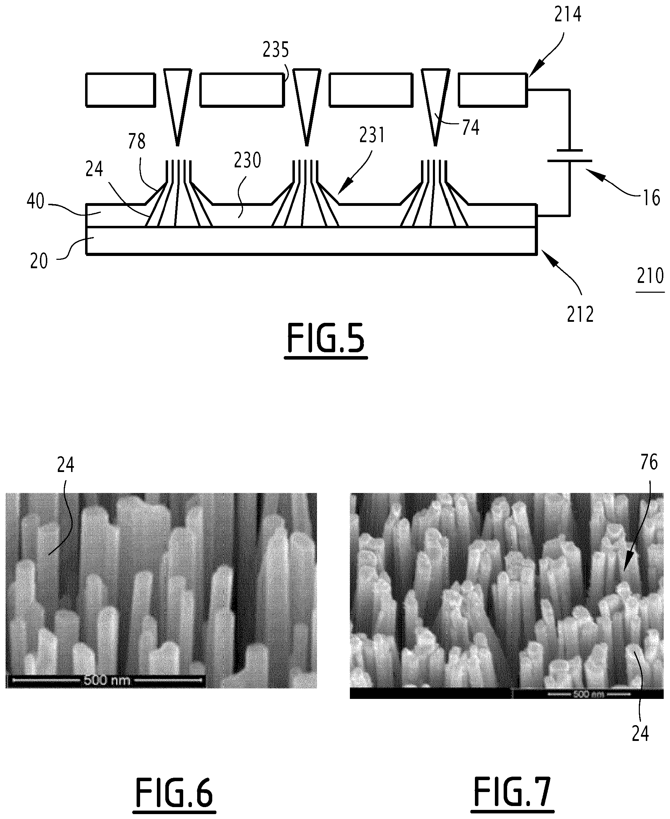

Dans le mode de réalisation de la figure 5, des tranchées 230 séparent différents groupes 231 de nanofils 24. Plus précisément, au niveau des tranchées 230, la surface supérieure du substrat 20 est dépourvue de nanofils 24. Les tranchées 230 forment par exemple deux séries de droites parallèles définissant un maillage en deux dimensions. De préférence, les séries de droites parallèles s'étendent respectivement selon X et selon Y, définissant un maillage carré. Selon une variante non représentée, les tranchées sont gravées selon une autre configuration, dépendant par exemple d'un motif à projeter.

L'électrode d'émission 12, 212 comporte en outre une source d'ions à liquide ionique 40. Ladite source d'ions comprend une nappe 42 de liquide ionique, formée sur la surface supérieure 22 du substrat 20. Le liquide ionique est par exemple un sel d'onium choisi parmi les composés utilisés en propulsion ionique, comme le EMI-BF₄ (tétrafluoroborate de 3-éthyl-1-méthylimidazolium) ou le EMI-IM (bis (trifluorométhylsulfonyl)imide de 3-éthyl-1-méthylimidazolium) décrits dans le document WO2009/137583.

La nappe 42 immerge au moins partiellement les nanofils 24. Plus précisément, les extrémités libres des nanofils 24 dépassent préférentiellement de la nappe 42 lorsque le générateur électrique 16 est désactivé. La nappe 42 est représentée schématiquement, notamment sur la figure 2, sans tenir compte des phénomènes de capillarité avec les nanofils.

La nappe 42 de liquide ionique forme ainsi une première surface principale 44 de l'électrode d'émission 12, ladite première surface principale 44 étant destinée à émettre un ou des faisceaux d'ions.

Dans le cadre du mode de réalisation de la figure 1, le boîtier 18 du générateur 10 va à présent être décrit. Le boîtier 18 comporte un fond 46, des parois latérales 48 et une cloison intermédiaire 50. Dans le mode de réalisation de la figure 1, la cloison intermédiaire 50 et les parois latérales 48 sont formées dans un matériau électriquement isolant, de préférence un plastique tel que l'acrylonitrile butadiène styrène (ABS).

Le fond 46 et la cloison intermédiaire 50 s'étendent sensiblement selon des plans (X, Y). Les parois latérales 48 s'étendent parallèlement à Z depuis le fond 46 jusqu'à un bord supérieur 52. Les parois latérales 48 forment de préférence une section carrée selon (X, Y).

La cloison intermédiaire 50 s'étend à partir des parois latérales 48, entre le fond 46 et le bord supérieur 52. La cloison intermédiaire 50 divise notamment le boîtier 18 entre une cavité d'émission 54 et un réservoir 56, respectivement situés au-dessus et en-dessous de ladite cloison intermédiaire.

La cloison intermédiaire 50 est formée d'un matériau microporeux. Sur la figure 1, des pores 58 dudit matériau sont schématisées sous forme agrandie par rapport au boîtier 18. Lesdites pores 58 mettent en communication fluidique le réservoir 56 et la cavité d'émission 54.

Une face supérieure de la cloison intermédiaire 50 est fixée à une face inférieure du substrat 20. Ledit substrat 20 et les nanofils 24 sont ainsi reçus dans la cavité d'émission 54 ; la cloison intermédiaire 50 forme un support de l'ensemble substrat 20 / nanofils 24.

Comme il sera détaillé par la suite, le réservoir 56 est destiné à recevoir une quantité de liquide ionique 40 pour former la nappe 42, par diffusion dudit liquide à travers les pores 58. En particulier, dans le mode de réalisation de la figure 1, les parois latérales 48 et la cloison intermédiaire 50 sont formées d'une pièce, tandis que le fond 46 du réservoir 56 est amovible.

L'électrode d'extraction 14, 114, 214 est formée d'un matériau électriquement conducteur ou semi-conducteur. L'électrode d'extraction 14, 114, 214 comporte par exemple un métal, notamment le tungstène ou l'acier inoxydable. Selon des variantes, l'électrode d'extraction 14, 114, 214 comporte un matériau conducteur non-métallique tel que le graphène et/ou un matériau semi-conducteur tel que le silicium.

L'électrode d'extraction 14, 114, 214 présente une deuxième surface principale 60 disposée en vis-à-vis de la première surface principale 44. Dans les modes de réalisation des figures 1, 4 et 5, la deuxième surface principale 60 est sensiblement disposée selon un plan (X, Y). Selon des variantes non représentées, la deuxième surface principale peut avoir une forme non plane.

Les première et deuxième surfaces principales sont séparées par un espace 62, d'un ordre de grandeur selon Z allant de quelques centaines de nanomètres à quelques dizaines de micromètres. De préférence, l'espace 62 a une longueur selon Z comprise entre 100 nm et 50 µm, plus préférentiellement comprise entre 500 nm et 10 µm.

En particulier, dans le mode de réalisation de la figure 1, l'électrode d'extraction 14 est fixée au bord supérieur 52 des parois latérales 48 du boîtier 18. Ledit boîtier est configuré de sorte à obtenir la longueur souhaitée pour l'espace 62.

La figure 3 montre une vue de détail de l'électrode d'extraction 14 de la figure 1, représentée en coupe. L'électrode d'extraction 14 comporte une grille 63 de fils métalliques 64, ladite grille s'étendant dans un plan (X, Y).

Les fils métalliques 64, par exemple en acier inoxydable, ont notamment un diamètre de l'ordre de la dizaine à la centaine de micromètres. Lesdits fils métalliques 64 sont de préférence tissés, deux fils voisins étant espacés de quelques centaines de micromètres.

L'électrode d'extraction 14 comporte en outre un feuillet 65, disposé sur la grille 63. Ledit feuillet 65 est formé d'un matériau électriquement conducteur tel qu'un métal ou du graphène. Le feuillet 65 présente de préférence une épaisseur de quelques Angströms selon Z.

La grille 63 et le feuillet 65 sont fixés au bord supérieur 52 des parois latérales 48 du boîtier 18. Avant la première émission ionique du générateur 10, le feuillet 65 est dépourvu d'ouvertures et ferme la cavité d'émission 54 de manière étanche aux gaz et aux liquides. Comme il sera décrit par la suite, le feuillet 65 est destiné à être perforé par un ou plusieurs faisceaux d'ions issus de l'électrode d'émission 12.

Selon des variantes non représentées, l'électrode d'émission d'un générateur de faisceau ionique selon l'invention peut être formée d'une grille 63 seule ou d'un feuillet 65 seul.

Dans le mode de réalisation de la figure 4, l'électrode d'extraction 114 est formée d'un échantillon à graver ou sur lequel effectuer un dépôt moléculaire ; la deuxième surface principale 60 de ladite électrode d'extraction est par exemple constituée de silicium.

Dans le mode de réalisation de la figure 5, l'électrode d'extraction 214 est formée par un matériau définissant un réseau de capillaires 235 s'étendant selon Z. Lesdits capillaires sont susceptibles de guider les faisceaux 74 émis.

Le générateur électrique 16 comporte une première borne 70, reliée à l'électrode d'émission 12, 212, et une deuxième borne 72 reliée à l'électrode d'extraction 14, 114, 214. Le générateur électrique 16 est notamment configuré pour permettre une inversion de polarités entre les première 70 et deuxième 72 bornes.

La première borne 70 est reliée directement à la source d'ions à liquide ionique 40 et en particulier à la nappe 42 de liquide ionique. Dans le mode de réalisation de la figure 1, la première borne 70 est matérialisée par une électrode de polarisation 73 disposée dans le réservoir 56. La deuxième borne 72 est reliée aux bords de la grille 63 et du feuillet 65.

Un procédé de mise en oeuvre du générateur de faisceau ionique 10, 110, 210 va maintenant être décrit, illustrés par des résultats expérimentaux obtenus à partir du mode de réalisation de la figure 1.

Tout d'abord, un substrat 20 recouvert de nanofils 24 est fourni. Selon un exemple ne faisant pas partie de l'invention les nanofils sont formés en nitrure de gallium par épitaxie moléculaire, comme décrit ci-après : un substrat monocristallin de silicium d'orientation cristalline <111> est traité in-situ par un procédé de nitruration ou d'oxydation pour en rendre la surface isolante juste avant l'opération d'épitaxie des nanofils. Les nanofils sont produits par exemple en utilisant la technique d'épitaxie par jets moléculaires qui consiste à diriger des flux d'atomes adéquats, selon l'exemple Ga et N, sur la surface du substrat Silicium <111> nitruré en surface. Les atomes déposés se réorganisent sur des points de nucléation répartis sur toute la surface. La croissance, l'espacement, le diamètre, le rapport d'aspect, la composition sont contrôlés par exemple en ajustant les paramètres de flux des espèces atomiques et/ou de la température.

Un nanofil va croître perpendiculairement au substrat en capturant les espèces atomiques déposées intentionnellement et disponibles par diffusion dans son voisinage immédiat. La compétition intra-fils pour capturer les espèces atomiques déposées va réguler les mécanismes de croissance. Le contrôle de la fonction d'apport des espèces déposées permet un contrôle précis.

Les nanofils 24 obtenus sont cristallins, donc homogènes. Le diamètre 27 a une faible variabilité pour un procédé donné.

Dans le mode de réalisation de la figure 5, une découpe des tranchées 230 est ensuite réalisée à la surface supérieure 22 du substrat 20, par exemple à l'aide d'une technique classique de lithographie sur silicium.

La figure 6 représente une photographie au microscope électronique des nanofils 24 d'un échantillon correspondant au mode de réalisation de la figure 1, avant l'ajout du liquide ionique. Sur la figure 6, on observe notamment que les nanofils 24 sont répartis sensiblement régulièrement sur le substrat et sont espacés les uns des autres.

En parallèle, dans le mode de réalisation de la figure 1, le boîtier 18 est réalisé. Le substrat 20 est ensuite fixé à la cloison intermédiaire 50, puis la cavité d'émission 54 est fermée par assemblage du boîtier 18 avec l'électrode d'extraction 14. Le réservoir 56 est rempli de liquide ionique 40 et assemblé à l'électrode de polarisation 73.

Le générateur électrique 16 est ensuite relié, d'une part à l'électrode de polarisation 14, 114, 214 et d'autre part au liquide ionique 40. En particulier, dans le mode de réalisation de la figure 1, le générateur 16 est relié à l'électrode de polarisation 73.

Une différence de potentiel est ensuite appliquée par ledit générateur électrique 16. Dans le mode de réalisation de la figure 1, le liquide ionique 40 ainsi polarisé s'infiltre dans la cavité d'émission 54 à travers les pores 58 de la cloison intermédiaire 50. La nappe 42 est ainsi formée, imprégnant au moins partiellement les nanofils 24 et formant la première surface principale 44 de l'électrode d'émission 12.

Ladite première surface principale 44 émet alors des faisceaux d'ions 74 en direction de la deuxième surface principale 60. Selon la polarité des première 70 et deuxième 72 bornes, les faisceaux sont composés d'ions positifs ou d'ions négatifs.

Le substrat 20, les nanofils 24 et les parois de la cavité d'émission 54 sont formés de matériaux pas ou peu conducteurs. Au niveau de l'électrode d'émission 12, 212, seul le liquide ionique 40 est donc polarisé lors de la mise en route du générateur électrique 16, ce qui optimise l'efficacité d'émission des faisceaux 74.

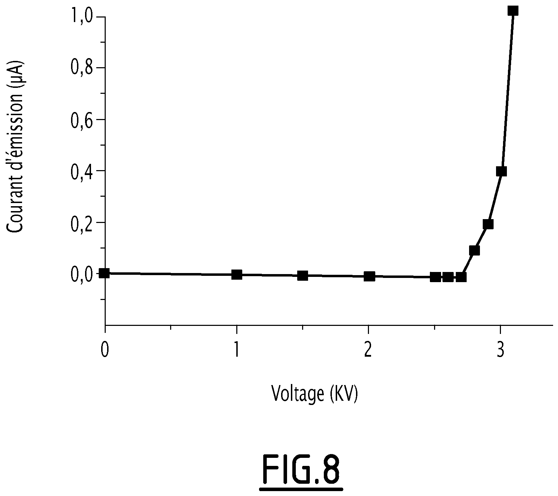

La figure 8 montre la variation d'un courant ionique émis par le générateur 10 de la figure 1 en fonction de la différence de potentiel appliquée entre les première 70 et deuxième 72 bornes du générateur électrique 16. Le courant d'émission est pratiquement nul jusqu'à l'obtention d'un voltage d'environ 2,8 KV, au-delà duquel le courant croît rapidement.

Le système présente une longévité importante. En particulier, le générateur 10 de la figure 1 a permis expérimentalement d'émettre durant plusieurs heures sans inversion de polarité des première 70 et deuxième 72 bornes.

Une interprétation du fonctionnement du générateur 10, 110, 210 est donnée ci-après : lors du dépôt de la nappe 42 sur le substrat 20, ou de l'application de la différence de potentiel par le générateur électrique 16, des nanofils 24 proches les uns des autres s'affaissent légèrement les uns sur les autres, pour former des structures coniques ou fagots 76. De tels fagots 76 sont notamment observables sur la figure 7, qui représente une photographie au microscope électronique de l'échantillon de la figure 6 après émission de faisceaux, nettoyage et séchage des nanofils.

Le nombre de nanofils 24 par fagot 76 varie notamment entre quelques unités et quelques dizaines. De manière optimale, les fagots 76 comprennent entre une et cinq dizaines de nanofils 24, regroupés sur une surface sensiblement circulaire d'environ 300 nm à 1 µm de diamètre. Une telle disposition conduit à une densité de l'ordre de 10⁸ sites émissifs par cm² de substrat 20, ce qui est supérieur aux résultats des générateurs ioniques connus.

Dans le cas du générateur 210 de la figure 5, la présence des tranchées 230 conduit préférentiellement chaque groupe 231 de nanofils 24 à former un fagot 76 distinct, ce qui permet de contrôler la taille dudit fagot. En outre, les tranchées 230 forment des canaux dans lequel le liquide ionique 40 peut circuler.

Il est également possible de contrôler l'orientation des nanofils 24 afin que les fagots 76 se forment spontanément avec une taille optimale lors de la mise en route du générateur électrique 16. De préférence, les nanofils 24 sont formés de sorte à obtenir une longueur 26 comprise entre 100 nm et 1 µm, un diamètre 27 d'environ 50 nm et une distance 28 entre deux nanofils voisins d'environ 150 nm. Par ailleurs, les nanofils 24 présentent une rigidité élevée, avec un module de Young supérieur ou égal à 120 GPa et préférentiellement de l'ordre de 150 GPa.

Sur un substrat 20 portant de tels nanofils 24, les fagots 76 se forment par autoorganisation desdits nanofils, sans nécessiter la présence de tranchées 230 organisant lesdits nanofils en groupes 231.

Les forces électrostatiques produisant l'émission d'ions à partir d'un liquide ionique sont très élevées, notamment de l'ordre de 10⁹ V/m. De telles forces appliquées à un ensemble de nanofils 24 et à la nappe 42 de liquide ionique sont de nature à induire une courbure, favorisant la formation de cônes de Taylor 78 (figures 4 et 5) sur la première surface principale 44 formée par la nappe 42.

Les fagots 76 permettent de conserver du liquide ionique 40 dans leur inter-espace, de sorte à recouvrir chaque nanofil 24 d'une couche fine de liquide ionique au niveau de son extrémité libre. Pour une application en propulsion spatiale, le carburant / liquide ionique doit être fragmenté en particules les plus élémentaires possibles pour récupérer un maximum de poussée. La disposition du liquide en couches fines sur les nanofils favorise donc l'efficacité du générateur ionique.

De plus, les fagots 76 assurent une protection physique du liquide ionique vis-à-vis de perturbations extérieures, telles que des rayonnements.

Les nanofils 24, formés d'un matériau pas ou peu conducteur, échappent aux phénomènes de dégradation, ou de formation de couche d'interface, observables dans le cas des aiguilles en matériau conducteur décrites dans le document WO2016/164004.

Par ailleurs, les nanofils 24 assemblés en fagots permettent, par capillarité, un renouvellement du liquide ionique au niveau de la pointe des cônes de Taylor. Par un phénomène de dilution, ce renouvellement évite la saturation en contre-ions au niveau desdites pointes, ce qui permet d'émettre plus longtemps sans inverser la polarité du générateur électrique 16. Une émission peut notamment être maintenue dans une polarité d'un signe donné pendant plusieurs heures, sans dégradation manifeste du liquide ionique.

De plus, la caractéristique courant / tension de l'ensemble des fagots reste pratiquement constante sur des durées de plusieurs heures et pour des volumes de liquide de moins d'un mL étalé sur une surface de nanofils de l'ordre de plusieurs mm².

Des tests comparatifs ont été réalisés avec des nanofils 24 isolés, par opposition avec la structure en fagots 76. Ces tests ont montré qu'il n'était pas possible d'obtenir le recouvrement par capillarité d'un nanofil isolé par une couche fine de liquide ionique. Le nanofil isolé se retrouve immergé sous une goutte de liquide ionique qui ne permet pas de stabiliser un cône de Taylor. Il en résulte une émission instable de gouttelettes de liquide ionique, ce qui diminue l'efficacité du générateur.

Le fonctionnement du générateur de faisceau d'ions selon l'invention permet notamment d'émettre des ions pendant une période étendue et de consommer une grande quantité de liquide ionique, sans dégradation des nanofils 24, au contraire des pointes métalliques décrites dans le document WO2009/137583. De telles propriétés rendent ces générateurs particulièrement avantageux pour la réalisation de propulseurs ioniques d'engins spatiaux, tels que des microsatellites de type CubeSat.

La poussée totale fournie par le propulseur est proportionnelle au nombre de sites actifs éjectant des ions. Le nombre très élevé de sites d'émission lié à la structure en fagots 76 est donc favorable à la poussée.

De plus, les cônes de Taylor obtenus par les générateurs ioniques selon l'invention sont de petite taille et contiennent des volumes réduits de liquide ionique. De tels cônes de Taylor sont connus de la littérature pour être hydrodynamiquement plus stables que des cônes de Taylor de grande taille. L'architecture des générateurs ioniques selon l'invention est donc plus efficace énergétiquement et plus facile à piloter, car la tension est notamment moins sujette à un phénomène d'hystérésis.

Dans le mode de réalisation de la figure 1, la cavité d'émission 54 est initialement fermée de manière étanche par le feuillet 65. Ce mode de réalisation permet de disposer d'un générateur dont le liquide ionique 40 est confiné dans une enceinte étanche au moment du lancement du satellite. Lorsque ce dernier est en orbite, le générateur 10 est activé, ce qui forme des ouvertures dans le feuillet 65 sous l'effet des faisceaux ioniques 74. Le feuillet 65 est ainsi perforé en vis-à-vis de chaque faisceau, formant un système auto-aligné.

Le mode de réalisation de la figure 4 est particulièrement adapté à la nanofabrication. Selon une première variante d'utilisation, les faisceaux ioniques 74 arrachent des molécules à la deuxième surface principale 60 de l'échantillon formant l'électrode d'extraction 114. Une telle utilisation permet de réaliser à l'échelle nanométrique des motifs en bas-relief dans l'échantillon, lesdits motifs correspondant au contour 29 du substrat 20.

Selon une deuxième variante d'utilisation du mode de réalisation de la figure 4, les faisceaux ioniques 74 permettent à des molécules chargées de quitter la nappe 42 de liquide ionique et de se greffer sur la deuxième surface principale 60. Une telle utilisation permet de réaliser des motifs en nano-dépôt sur l'échantillon.

Le choix du liquide ionique et de la différence de potentiel appliquée permet de contrôler l'effet des faisceaux ioniques, en termes d'arrachage ou de greffage des molécules.

Le mode de réalisation de la figure 1 peut également être utilisé en nano-fabrication, en disposant un échantillon cible au-dessus de l'électrode d'extraction 14 sous forme de grille. Ladite électrode d'extraction est traversée par les faisceaux avant que ces derniers n'atteignent une surface de l'échantillon à modifier. La présence d'une électrode d'extraction entre la cible et l'électrode d'émission permet de moduler plus précisément l'énergie du faisceau incident sur la cible.

Le générateur de faisceau d'ions selon l'invention trouve ainsi une application dans des domaines variés, avec une efficacité améliorée par rapport aux dispositifs d'émission ioniques connus.

## Revendications

1. Générateur (10, 110, 210) de faisceau ionique (64), comprenant :
- une électrode d'émission (12, 212), comprenant une première surface principale (44) ;
- une électrode d'extraction (14, 114, 214), comprenant une deuxième surface principale (60) disposée sensiblement en vis-à-vis de la première surface principale, lesdites première et deuxième surfaces principales étant séparées par un espace (62) ; et
- un générateur électrique (16) apte à appliquer une différence de potentiel entre l'électrode d'émission et l'électrode d'extraction ;
l'électrode d'émission comprenant une source d'ions à liquide ionique (40), ladite électrode d'émission étant ainsi apte à envoyer vers l'électrode d'extraction au moins un faisceau (74) d'ions issus dudit liquide ionique ;
**caractérisé en ce que** :
- l'électrode d'émission comporte un substrat (20) et une pluralité de nanofils (24) s'étendant à partir dudit substrat, sensiblement en direction de l'électrode d'extraction, chacun desdits nanofils ayant une longueur (26) comprise entre 50 nm et 50 µm, préférentiellement comprise entre 100 nm et 1 µm, chacun desdits nanofils ayant un diamètre (27) compris entre 50 nm et 200 nm, une distance minimale (28) entre deux nanofils voisins sur le substrat étant comprise entre 50 nm et 200 nm et préférentiellement égale à environ 150 nm ;
- la source d'ions à liquide ionique comprend une nappe (42) de liquide ionique formée sur le substrat et immergeant au moins partiellement les nanofils, ladite nappe de liquide ionique formant ainsi au moins partiellement la première surface principale (44) ; et
- la pluralité de nanofils et le substrat sont électriquement isolant, le générateur électrique (16) étant relié à la nappe (42) de liquide ionique.

2. Générateur de faisceau ionique selon la revendication 1, dans lequel les nanofils (24) de l'électrode d'émission sont obtenus par un apport de matière sur le substrat (20), lesdits nanofils étant préférentiellement réalisés par épitaxie moléculaire.

3. Générateur de faisceau ionique selon la revendication 1 ou la revendication 2, dans lequel les nanofils (24) sont formés de AIN.

4. Générateur de faisceau ionique selon l'une des revendications précédentes, dans lequel le substrat (20) de l'électrode d'émission est formé d'un matériau comprenant du silicium.

5. Générateur de faisceau ionique selon l'une des revendications précédentes, dans lequel les nanofils (24) s'étendent à partir d'une surface (22) sensiblement plane du substrat.

6. Générateur de faisceau ionique selon l'une des revendications précédentes, dans lequel le liquide ionique est un sel d'onium, préférentiellement choisi parmi le tétrafluoroborate de 3-éthyl-1-méthylimidazolium et le bis (trifluorométhyl-sulfonyl)imide de 3-éthyl-1-méthylimidazolium.

7. Générateur de faisceau ionique selon l'une des revendications précédentes, dans lequel l'espace (62) séparant les première et deuxième surfaces principales a une longueur comprise entre 100 nm et 50 µm, préférentiellement comprise entre 500 nm et 10 µm.

8. Générateur de faisceau ionique selon l'une des revendications précédentes, dans lequel :
- la longueur (26) d'un nanofil (24) est comprise entre 100 nm et 1 µm ;
- le diamètre (27) d'un nanofil est d'environ 50 nm ;
- la distance minimale (28) entre deux nanofils voisins sur le substrat est d'environ 150 nm ; et
- un module de Young des nanofils est supérieur ou égal à 120 GPa et préférentiellement de l'ordre de 150 GPa.

9. Générateur de faisceau ionique selon l'une des revendications précédentes, dans lequel l'électrode d'extraction (14) comporte une grille (63) préférentiellement formée de fils (64) tissés.

10. Générateur de faisceau ionique selon l'une des revendications précédentes, dans lequel l'électrode d'extraction (14) comporte un feuillet (65) apte à être perforé par un faisceau d'ions issu de l'électrode d'émission.

11. Générateur de faisceau ionique selon la revendication 10, dans lequel l'électrode d'émission (12) est disposée dans un compartiment (54) fermé de manière étanche par le feuillet (65).

12. Propulseur ionique comprenant un générateur de faisceau ionique selon l'une des revendications précédentes.

13. Dispositif de nano-fabrication comprenant un générateur de faisceau ionique selon l'une des revendications 1 à 11.

## Patentansprüche

1. Generator (10, 110, 210) für einen lonenstrahl (64), der Folgendes umfasst:
- eine Emissionselektrode (12, 212), die eine erste Hauptfläche (44) umfasst;
- eine Extraktionselektrode (14, 114, 214), die eine zweite Hauptfläche (60) umfasst, die im Wesentlichen gegenüber der ersten Hauptfläche angeordnet ist, wobei die erste und zweite Hauptfläche durch einen Zwischenraum (62) getrennt sind; und
- einen elektrischen Generator (16), der dazu geeignet ist, eine Potentialdifferenz zwischen der Emissionselektrode und der Extraktionselektrode anzulegen ;
wobei die Emissionselektrode eine lonenquelle mit ionischer Flüssigkeit (40) umfasst,
wobei die Emissionselektrode dazu geeignet ist, mindestens einen Strahl (74) von Ionen, die aus der ionischen Flüssigkeit stammen, zur Extraktionselektrode zu senden;
**dadurch gekennzeichnet, dass**
- die Emissionselektrode ein Substrat (20) und eine Vielzahl von Nanodrähten (24) umfasst, die sich von dem Substrat aus im Wesentlichen in Richtung der Extraktionselektrode erstrecken,
wobei jeder der Nanodrähte eine Länge (26) zwischen 50 nm und 50 µm, vorzugsweise zwischen 100 nm und 1 µm aufweist, wobei jeder der Nanodrähte einen Durchmesser (27) zwischen 50 nm und 200 nm aufweist, wobei ein minimaler Abstand (28) zwischen zwei benachbarten Nanodrähten auf dem Substrat zwischen 50 nm und 200 nm und vorzugsweise etwa 150 nm beträgt;
- die lonenquelle mit ionischer Flüssigkeit eine Schicht (42) aus ionischer Flüssigkeit umfasst, die auf dem Substrat gebildet ist und in die die Nanodrähte zumindest teilweise eintauchen, wobei die Schicht aus ionischer Flüssigkeit dadurch zumindest teilweise die erste Hauptoberfläche (44) bildet; und
- die Vielzahl von Nanodrähten und das Substrat elektrisch isolierend sind, wobei der elektrische Generator (16) mit der Schicht (42) aus ionischer Flüssigkeit verbunden ist.

2. lonenstrahlgenerator nach Anspruch 1, wobei die Nanodrähte (24) der Emissionselektrode durch ein Aufbringen von Material auf das Substrat (20) erhalten sind, wobei die Nanodrähte vorzugsweise durch molekulare Epitaxie hergestellt sind.

3. lonenstrahlgenerator nach Anspruch 1 oder Anspruch 2, wobei die Nanodrähte (24) aus AIN gebildet sind.

4. lonenstrahlgenerator nach einem der vorhergehenden Ansprüche, wobei das Substrat (20) der Emissionselektrode aus einem Material gebildet ist, das Silizium enthält.

5. lonenstrahlgenerator nach einem der vorhergehenden Ansprüche, wobei sich die Nanodrähte (24) von einer im Wesentlichen ebenen Oberfläche (22) des Substrats aus weg erstrecken.

6. lonenstrahlgenerator nach einem der vorhergehenden Ansprüche, wobei die ionische Flüssigkeit ein Oniumsalz ist, das vorzugsweise aus 3-Ethyl-1-methylimidazoliumtetrafluoroborat und 3-Ethyl-1-methylimidazoliumbis(trifluormethylsulfonyl)imid ausgewählt ist.

7. lonenstrahlgenerator nach einem der vorhergehenden Ansprüche, wobei der Zwischenraum (62), der die erste und zweite Hauptfläche trennt, eine Länge zwischen 100 nm und 50 µm, vorzugsweise zwischen 500 nm und 10 µm, aufweist.

8. lonenstrahlgenerator nach einem der vorhergehenden Ansprüche, wobei:
- die Länge (26) eines Nanodrahts (24) zwischen 100 nm und 1 µm liegt;
- der Durchmesser (27) eines Nanodrahts etwa 50 nm beträgt;
- der Mindestabstand (28) zwischen zwei benachbarten Nanodrähten auf dem Substrat etwa 150 nm beträgt; und
- ein Elastizitätsmodul der Nanodrähte größer oder gleich 120 GPa und vorzugsweise in der Größenordnung von 150 GPa ist.

9. lonenstrahlgenerator nach einem der vorhergehenden Ansprüche, wobei die Extraktionselektrode (14) ein Gitter (63) aufweist, das vorzugsweise aus gewebten Fäden (64) gebildet ist.

10. lonenstrahlgenerator nach einem der vorhergehenden Ansprüche, wobei die Extraktionselektrode (14) ein Blatt (65) aufweist, das von einem von der Emissionselektrode ausgehenden lonenstrahl perforiert werden kann.

11. lonenstrahlgenerator nach Anspruch 10, wobei die Emissionselektrode (12) in einer Kammer (54) angeordnet ist, die durch die Folie (65) dicht verschlossen ist.

12. Ionentriebwerk mit einem lonenstrahlgenerator nach einem der vorhergehenden Ansprüche.

13. Nanofertigungsvorrichtung mit einem lonenstrahlgenerator nach einem der Ansprüche 1 bis 11.

## Claims

1. Ion beam (64) generator (10, 110, 210), comprising:
- an emission electrode (12, 212) comprising a first main surface (44);
- an extraction electrode (14, 114, 214) comprising a second main surface (60) arranged substantially facing the first main surface, said first and second main surfaces being separated by a gap (62); and
- an electrical generator (16) capable of applying a potential difference between the emission electrode and the extraction electrode;
the emission electrode comprising an ionic liquid ion source (40), said emission electrode thus being capable of sending at least one beam (74) of ions originating from said ionic liquid to the extraction electrode;
**characterized in that**:
- the emission electrode comprises a substrate (20) and a plurality of nanowires (24) extending from said substrate, substantially in the direction of the extraction electrode, each of said nanowires having a length (26) comprised between 50 nm and 50 µm, preferentially comprised between 100 nm and 1 µm, each of said nanowires having a diameter (27) comprised between 50 nm and 200 nm, a minimum distance (28) between two adjacent nanowires on the substrate being comprised between 50 nm and 200 nm and preferentially equal to approximately 150 nm;
- the ionic liquid ion source comprises a layer (42) of ionic liquid formed on the substrate and at least partially immersing the nanowires, said layer of ionic liquid thus at least partially forming the first main surface (44); and
- the plurality of nanowires and the substrate are electrically insulating, the electrical generator (16) being connected to the layer (42) of ionic liquid.

2. Ion beam generator according to claim 1, in which the nanowires (24) of the emission electrode are obtained by adding material to the substrate (20), said nanowires being preferentially produced by molecular beam epitaxy.

3. Ion beam generator according to claim 1 or claim 2, in which the nanowires (24) are formed from AIN.

4. Ion beam generator according to one of the preceding claims, in which the substrate (20) of the emission electrode is formed from a material comprising silicon.

5. Ion beam generator according to one of the preceding claims, in which the nanowires (24) extend from a substantially flat surface (22) of the substrate.

6. Ion beam generator according to one of the preceding claims, in which the ionic liquid is an onium salt, preferentially selected from 3-ethyl-1-methylimidazolium tetrafluoroborate and 3-ethyl-1-methylimidazolium bis(trifluoromethylsulfonyl)imide.

7. Ion beam generator according to one of the preceding claims, in which the gap (62) separating the first and second main surfaces has a length comprised between 100 nm and 50 µm, preferentially comprised between 500 nm and 10 µm.

8. Ion beam generator according to one of the preceding claims, in which:
- the length (26) of a nanowire (24) is comprised between 100 nm and 1 µm;
- the diameter (27) of a nanowire is approximately 50 nm;
- the minimum distance (28) between two adjacent nanowires on the substrate is approximately 150 nm; and
- a Young's modulus of the nanowires is greater than or equal to 120 GPa and preferentially of the order of 150 GPa.

9. Ion beam generator according to one of the preceding claims, in which the extraction electrode (14) comprises a grid (63) preferentially formed from woven wires (64).

10. Ion beam generator according to one of the preceding claims, in which the extraction electrode (14) comprises a sheet (65) capable of being perforated by an ion beam originating from the emission electrode.

11. Ion beam generator according to claim 10, in which the emission electrode (12) is arranged in a compartment (54) tightly closed by the sheet (65).

12. Ion thruster comprising an ion beam generator according to one of the preceding claims.

13. Nanofabrication device comprising an ion beam generator according to one of claims 1 to 11.
